# EUROPEAN PATENT SPECIFICATION

(11) **EP 2 544 230 B1**
(45) Date of publication and mention of the grant of the patent: **19.06.2019**
(21) Application number: 12174737.2
(22) Date of filing: 03.07.2012
(51) Int. Cl.: H01L 25/065, H05K 1/18, G11C 5/04

(54) **Semiconductor module and module substrate**
Halbleitermodul und Halbleitersubstrat
Module semi-conducteur et substrat de module

(30) Priority: 04.07.2011 JP 2011148548
(43) Date of publication of application: 09.01.2013
(73) Proprietor: Longitude Licensing Limited, Dublin D18 P3Y9 (IE)
(72) Inventor: Tsukada, Wataru, Chuo-ku, Tokyo 104-0028 (JP)
(74) Representative: FRKelly

(56) References cited:
- DE-A1-102004 021 226
- US-A1- 2009 196 009
- US-A1- 2010 312 956
- US-B1- 6 594 167
- US-B1- 6 632 705

## Description

### BACKGROUND OF THE INVENTION

### --Field of the Invention

The present invention relates to a semiconductor module and a module substrate, and more particularly relates to a semiconductor module on which a plurality of semiconductor devices such as memory devices are mounted and a module substrate used for the semiconductor module.

### --Description of Related Art

A memory device represented by a DRAM (Dynamic Random Access Memory) is normally used in a state where a plurality of memory devices are mounted on a module substrate (see Japanese Patent Application Laid-open Nos. 2001-84754 and 2009-182163). In many semiconductor modules, semiconductor devices mounted on the module substrate are arranged to face the same direction. Semiconductor modules described in Japanese Patent Application Laid-open Nos. 2001-84754 and 2009-182163 are intended to make lines formed on the module substrate lower in line density and equal in length by optimizing the direction of mounting the semiconductor devices.

In a case of the semiconductor module described in Japanese Patent Application Laid-open No. 2001-84754, semiconductor devices are arranged in two rows along the long side direction of the module substrate, and the direction of the semiconductor devices arranged in one row differ from that of the semiconductor devices arranged in the other row by 180°. This layout can prevent interference between data lines connected to the semiconductor devices in one row and those connected to the semiconductor devices in the other row.

Similarly, in a case of the semiconductor module described in Japanese Patent Application Laid-open No. 2009-182163, semiconductor devices are arranged in two rows along the long side direction of the module substrate, and the two adjacent semiconductor devices differ in direction by 90°. The semiconductor devices that are arranged in the same mounting direction are connected, thereby making lines lower in density and equal in length.

However, the semiconductor module described in Japanese Patent Application Laid-open No. 2001-84754 has the following problems. That is, because of the same direction of the semiconductor devices mounted in each row, it is necessary to arrange the line necessary to connect by fly-by connection such as address signals so that the lines meander in a narrow space. This causes an increase in line density.

Meanwhile, the semiconductor module described in Japanese Patent Application Laid-open No. 2009-182163 has the following problem. That is, because a mixture of horizontal semiconductor devices and vertical semiconductor devices are mounted despite reduced line density, mounting margins may be insufficient in the short side direction of the module substrate. This problem becomes particularly serious for semiconductor modules of such a type as to mount a plurality of register buffers along the long side direction of the module substrate in addition to memory devices such as DRAMs.

Further reference is made to document DE 10 2004 021 226 A1 which discloses a semiconductor module comprising a plurality of semiconductor devices arranged in horizontal and vertical directions, wherein devices that are adjacent in horizontal direction are mounted in opposite directions.

### SUMMARY

A semiconductor module according to the present invention is defined in appended claim 1.

A module substrate according to the present invention is defined in appended claim 7.

According to the present invention, a density of signal lines provided on the module substrate can be lowered with keeping equal length of the signal lines because it is possible to connect the via conductors corresponding to the two semiconductor devices located diagonally at a shortest distance without any detours.

### BRIEF DESCRIPTION OF THE DRAWINGS

FIGs. 1A and 1B are external views indicative of an embodiment of a semiconductor module according to an embodiment of the present invention, FIG. 1A is a plan view of the semiconductor module as viewed from one surface, and FIG. 1B is a plan view of the semiconductor module as viewed from the other surface;
FIG. 2 is a pattern diagram for explaining mounting directions of two DRAMs facing each other across a module substrate 20;
FIG. 3 is a schematic plan view indicative of an example of a layout of terminals provided on each DRAM;
FIG. 4 is a pattern diagram for explaining a structure of a DRAM mounting area on the module substrate 20;
FIG. 5 is a pattern diagram for explaining a connection relation between a command address buffer 300 and DRAMs 101 to 118;
FIG. 6 is a pattern diagram for explaining lines connected to some DRAMs and some register buffers;
FIG. 7 is a schematic view for explaining a problem in a first comparative example;
FIG. 8 is a schematic view for explaining a problem in a second comparative example;
FIG. 9 is a schematic view for explaining a problem in a third comparative example;
FIG. 10 is a schematic view for explaining a problem in a fourth comparative example;
FIG. 11 is a schematic cross-sectional view for explaining a structure of line layers included in the module substrate 20;
FIG. 12 is a schematic cross-sectional view for explaining a structure of line layers according to a modification; and
FIG. 13 is a perspective view indicative of an embodiment of a configuration of a motherboard 51 on which the semiconductor module 10 is mounted.

### DETAILED DESCRIPTION OF THE EMBODIMENTS

Preferred embodiments of the present invention will be explained below in detail with reference to the accompanying drawings.

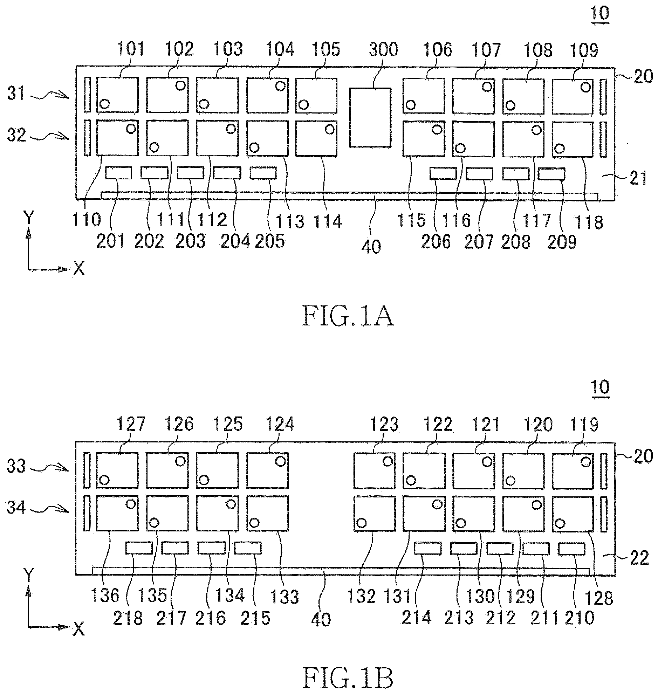

Turning to FIGs. 1A and 1B, a semiconductor module 10 according to the present embodiment includes a module substrate 20, and DRAMs 101 to 136, register buffers 201 to 218, and a command address buffer 300 that are mounted on the module substrate 20. The module substrate 20 is a substrate having a multilayer wiring structure, and the DRAMs 101 to 136 and the register buffers 201 to 218 are mounted on both surfaces of the module substrate 20 as shown in FIGs. 1A and 1B. The module substrate 20 is a rectangular substrate having long sides in an X direction and short sides in Y direction. Each of one surface 21 and the other surface 22 has two DRAM-mounting area rows in the X direction.

More specifically, the DRAMs 101 to 118, the register buffers 201 to 201, and the command address buffer 300 are mounted on one surface 21 of the module substrate 20. The DRAMs 101 to 109 are mounted in an upper mounting area row 31, and the DRAMs 110 to 118 are mounted in a lower mounting area row 32. A connector area 40 constituted by a plurality of connector pins is provided on one of the long sides of the module substrate 20, and the register buffers 201 to 209 are arranged between the DRAMs 101 to 118 and the connector area 40 along the connector area 40 in the X direction. The command address buffer 300 is mounted between the DRAMs 105 and 114 and the DRAMs 106 and 115.

Similarly, the DRAMs 119 to 136 and the register buffers 210 to 218 are mounted on the other surface 22 of the module substrate 20. The DRAMs 119 to 127 are mounted in an upper mounting area row 33, and the DRAMs 128 to 136 are mounted in a lower mounting area row 34. The register buffers 210 to 218 are arranged between the DRAMs 119 to 136 and the connector area 40 along the connector area 40 in the X direction. The DRAMs 119 to 136 are arranged at positions just at the back of the DRAMs 101 to 118, respectively. In other words, the DRAMs 101 to 118 match the DRAMs 119 to 136 in plan positions, respectively.

The register buffers 201 to 218 are semiconductor chips for buffering read data output from the DRAMs 101 to 136, and buffering write data to be written to the DRAMs 101 to 136. The nine register buffers 201 to 209 or 210 to 218 are mounted on each of the surfaces 21 and 22 of the module substrate 20, and each of the nine register buffers 201 to 209 or 210 to 218 is allocated to the two DRAMs equal in an X coordinate. For example, the register buffer 201 is allocated to the DRAMs 101 and 110, and the register buffer 202 is allocated to the DRAMs 102 and 111. In this way, the register buffers 201 to 218 buffer the read data and the write data, thereby considerably reducing load capacities of the connector pins for data. This configuration can reduce rounding of data waveforms, and can therefore realize high-speed data transfer.

The command address buffer 300 is a semiconductor chip for buffering command signals, address signals, control signals, clock signals, and the like supplied to the DRAMs 101 to 136. Therefore, these signals output from an external memory controller are temporarily input to the command address buffer 300, and the signals buffered by the command address buffer 300 are supplied to the DRAMs 101 to 136.

The command address buffer 300 is connected to the DRAMs 101 to 136 by so-called fly-by connection. More specifically, the 36 DRAMs 101 to 136 are divided into four groups and each group is connected to the command address buffer 300 by the fly-by connection. A first group includes the DRAMs 101, 103, 105, 111, 113 and the DRAMs 119, 121, 123, 129, and 131 arranged on the back surface of the DRAMs 101, 103, 105, 111, 113, respectively. A second group includes the DRAMs 102, 104, 110, 112, and 114 and the DRAMs 120, 122, 128, 130, and 132 arranged on the back surface of the DRAMs 102, 104, 110, 112, and 114, respectively. A third group includes the DRAMs 106, 108, 116, and 118 and the DRAMs 124, 126, 134, and 136 arranged on the back surface of the DRAMs 106, 108, 116, and 118, respectively. A fourth group includes the DRAMs 107, 109, 115, and 117 and the DRAMs 125, 127, 133, and 135 arranged on the back surface of the DRAMs 107, 109, 115, and 117, respectively.

In FIGs. 1A and 1B, the symbol "o" attached to each DRAM is an index that indicates a direction in which the DRAM is mounted. The DRAMs 101 to 136 are semiconductor packages having the same structure. The DRAMs 101 to 136 are rectangular packages each having long sides and short sides in a plan view. Each of the DRAMs 101 to 136 is mounted on the module substrate 20 so that the long sides are in the X direction and the short sides are in the Y direction. Therefore, it means that the DRAM (the DRAM 101, for example) having the index added at a lower left position and the DRAM (the DRAM 102, for example) having the index added at an upper right position differ in the mounting direction by 180°. In the present embodiment, the two DRAMs (the DRAMs 101 and 102, for example) adjacent in the X direction differ in the mounting direction by 180°, and the two DRAMs (the DRAMs 101 and 110, for example) adjacent in the Y direction differ in the mounting direction by 180°. A plurality of DRAMs having the same mounting direction constitute each of the above four groups.

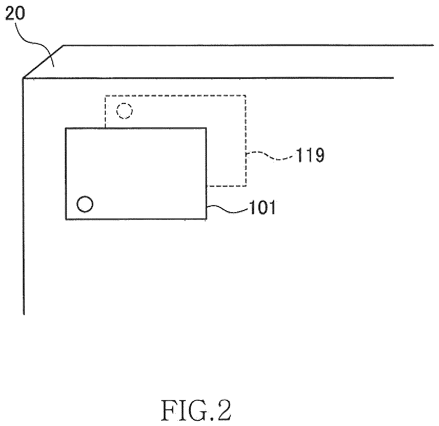

Turning to FIG. 2, the DRAMs 101 and 119 are shown as an example. These DRAMs 101 and 119 are arranged to face each other across the module substrate 20, and FIG. 2 shows the index of the DRAM 119 in a perspective view. The index of the DRAM 119 is located at an upper left position in the perspective view. Because the index of the DRAM 101 is at the lower left position, it can be said that the DRAM 119 is in a state of rotating the DRAM 101 about a rotational axis that is a centerline extending in a long side direction of the DRAM 101.

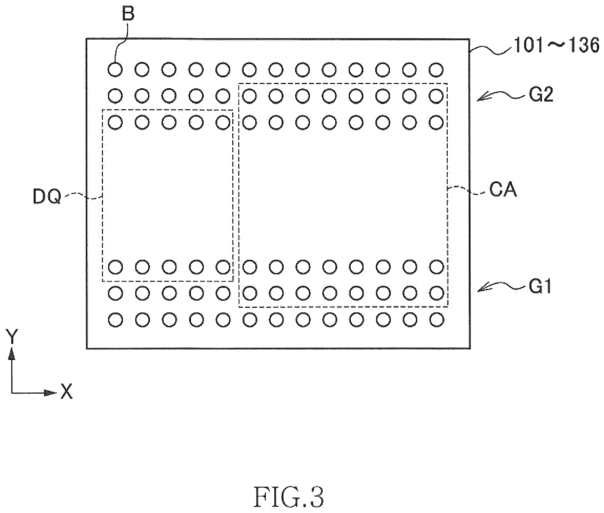

Turning to FIG. 3, each DRAM is in a state where a bare chip is packaged. And thus terminals B shown in FIG. 3 are terminals (so-called balls) on a package. The number of bare chips mounted in one package is not limited to one but two or more bare chips can be included in one package.

In an example shown in FIG. 3, the terminals B provided on each of the DRAMs 101 to 136 are arranged while being divided into two terminal groups G1 and G2, and the terminal groups G1 and G2 are separated from each other in the Y direction. Each of the terminal groups G1 and G2 is configured so that the terminals B are arranged in three rows in the X direction. While which signal is allocated to which terminal is set by a standard, signals of the same type are collected together in one place. As an example, reference character CA shown in FIG. 3 denotes a terminal group to which command address-related signals such as command signals, address signals, control signals, and clock signals are allocated. Reference character DQ shown in FIG. 3 denote a terminal group to which data-related signals such as data signals and data strobe signals are allocated.

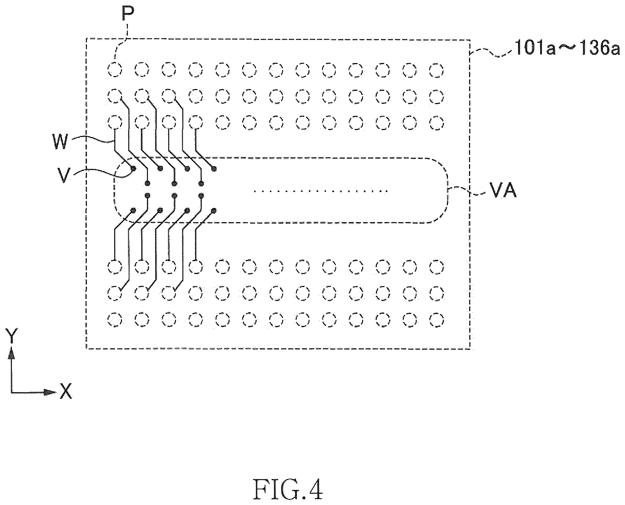

Turning to FIG. 4, reference characters 101a to 136a refer to areas in which the DRAMs 101 to 136 are mounted, respectively. In each of the mounting areas, pads P connected to the terminals B of each of the DRAMs 101 to 136 are provided. Needless to mention, the pads P match the terminals B in layout. The pads P are connected to via conductors V through lines W provided on each of the surfaces 21 and 22 of the module substrate 20, respectively. The via conductors V are provided to penetrate the module substrate 20, whereby the corresponding terminals B on the two DRAMs that are mounted on the front and back surfaces 21 and 22 of the module substrate 20 are short-circuited to one another and connected to predetermined line layers provided within the module substrate 20.

The via conductors V are formed in an area sandwiched between the terminal groups G1 and G2 shown in FIG. 3. Accordingly, a via area VA in which the via conductors V are formed is of a shape long in the X direction. It is not essential that a layout of the via conductors V provided in the via area VA is common to all the mounting areas 101a to 136a, but the layout can be made slightly different among the mounting areas 101a to 136a. However, as described above, the via conductors V provided in the via area VA substantially match in layout spontaneously because the layout of the terminals B provided on each of the DRAMs 101 to 136 is set by the standard and is, therefore, common to the DRAMs 101 to 136. Accordingly, as in the example shown in FIG. 3, when the data-related terminals DQ are collectively arranged at the left of each DRAM and the command address-related terminals CA are collectively arranged at the right of each DRAM, the layout of the via conductors V is such that the via conductors V connected to the data-related terminals DQ are arranged at the left of each of the mounting areas 101a to 136a, and that those connected to the command address-related terminals CA are arranged at the right of each of the mounting areas 101a to 136a. Therefore, the mounting areas 101a to 136a have directions corresponding to the DRAMs 101 to 136, respectively, and the directions are defined by the layout of the pads P or the via conductors V.

As described above, in the present embodiment, the two DRAMs (the DRAMs 101 and 102, for example) adjacent in the X direction differ in the mounting direction by 180°, and the two DRAMs (the DRAMs 101 and 110) adjacent in the Y direction differ in the mounting direction by 180°. The two mounting areas (the mounting areas 101a and 102a, for example) adjacent in the X direction differ in the direction by 180°, and the two mounting areas (the mounting area 101a and a mounting area 110a, for example) adjacent in the Y direction differ in the direction by 180°, accordingly.

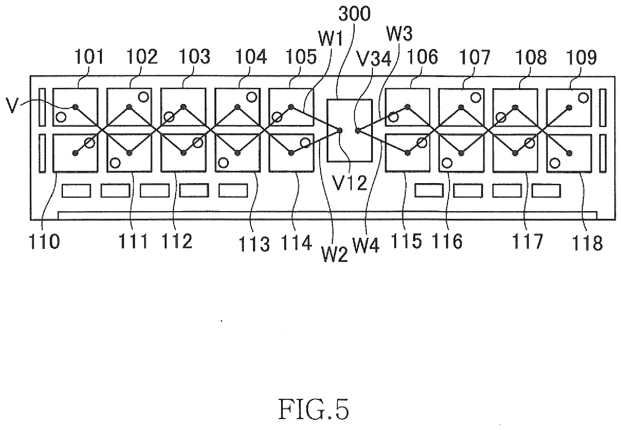

Turning to FIG. 5, as described above, the command address buffer 300 is connected to the DRAMs 101 to 118 in the four groups by the fly-by connection, respectively. The same holds true for the DRAMs 119 to 136 on the back surface 22. As shown in FIG. 5, the DRAMs 101, 103, 105, 111, and 113 that constitute the first group are commonly connected to the command address buffer 300 by a line W1. The DRAMs 102, 104, 110, 112, and 114 that constitute the second group are commonly connected to the command address buffer 300 by a line W2. The lines W1 and W2 are provided on a line layer within the module substrate 20 and branch off at a via conductor V12 provided right under the command address buffer 300. Therefore, the lines W1 and W2 are commonly connected to an output terminal of the command address buffer 300.

The DRAMs 106, 108, 116, and 118 that constitute the third group are commonly connected to the command address buffer 300 by a line W3. The DRAMs 107, 109, 115, and 117 that constitute the fourth group are commonly connected to the command address buffer 300 by a line W4. The lines W3 and W4 are provided on a line layer within the module substrate 20 and branch off at a via conductor V34 provided right under the command address buffer 300. Therefore, the lines W3 and W4 are commonly connected to the output terminal of the command address buffer 300.

In this way, in the present embodiment, the plural DRAMs connected by the fly-by connection are mounted in a zigzag manner, and the DRAMs connected by the fly-by connection match in the mounting direction. This configuration can make the lines provided on the module substrate 20 low in density and equal in length. The lines provided on the module substrate 20 are explained below more specifically.

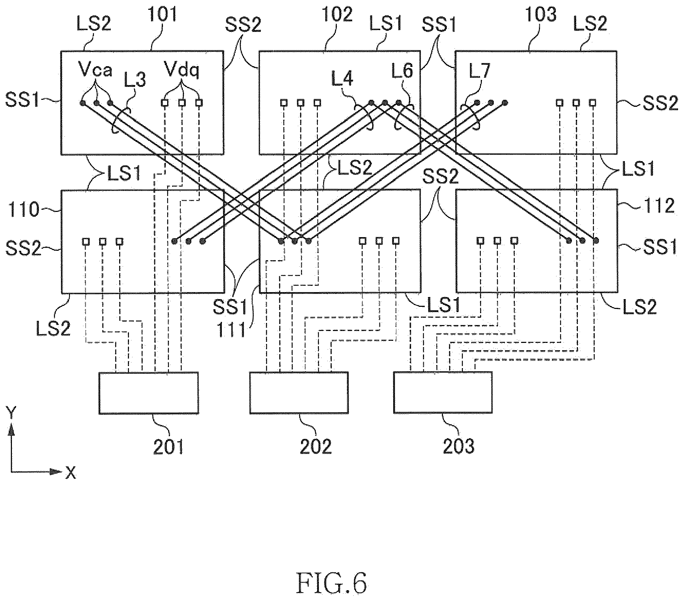

Turning to FIG. 6, the black circle denotes a command-address-related via conductor Vca, and the outlined quadrangle denotes a command-address-related via conductor Vdq.

FIG. 6 shows a connection relation among the six DRAMs 101 to 103 and 110 to 112, and that between these DRAMs and the register buffers 201 to 203. Among these DRAMs, the DRAMs 101, 103, and 111 are arranged in the same mounting direction and constitute the first group shown in FIG. 5. The DRAMs 102, 110, and 112 are arranged in the same mounting direction and constitute the second group shown in FIG. 5. The mounting direction of the DRAMs 101, 103, and 111 that constitute the first group differ by 180° from the mounting direction of the DRAMs 102, 110, and 112 that constitute the second group. Because the DRAMs constituting the first group and the DRAMs constituting the second group are alternately arranged, each DRAM differs in the mounting direction from the adjacent DRAM whether the two DRAMs are adjacent in the X or Y direction by 1.80°.

Accordingly, when plan directions of these DRAMs are made uniform so that the terminals B provided thereon match one another in layout, the corresponding short sides are defined as SS1 and SS2, and the corresponding long sides are defined as LS1 and LS2, then the DRAMs 110 and 111 are mounted so that the short sides SS1 face each other, the DRAM 101 and 110 are mounted so that the long sides LS1 face each other, the DRAMs 101 and 102 are mounted so that the short sides SS2 face each other, and the DRAMs 102 and 111 are mounted so that the long sides LS2 face each other.

In an example shown in FIG. 6, the via conductors Vca corresponding to the DRAMs 101 and 111 constituting the first group are connected to one another via the lines provided on a line layer L3 within the module substrate 20. The via conductors Vca corresponding to the DRAMs 103 and 111 constituting the first group are connected to one another via the lines provided on a line layer L7 within the module substrate 20. Because the DRAMs 101, 103, and 111 that constitute the first group are arranged in the same mounting direction, the command-address-related via conductors Vca are substantially arranged in the same array. Therefore, as shown in FIG. 6, it is possible to connect the via conductors Vca corresponding to the two DRAMs located diagonally at a shortest distance without any detours.

Furthermore, the via conductors Vca corresponding to the DRAMs 102 and 110 constituting the second group are connected to one another via the lines provided on a line layer L4 within the module substrate 20. The via conductors Vca corresponding to the DRAMs 102 and 112 constituting the second group are connected to one another via the lines provided on a line layer L6 within the module substrate 20. Because the DRAMs 102, 110, and 112 that constitute the second group are arranged in the same mounting direction, the command-address-related via conductors Vca are arranged substantially in the same array. Therefore, as shown in FIG. 6, it is possible to connect the via conductors Vca corresponding to the two DRAMs located diagonally at a shortest distance without any detours.

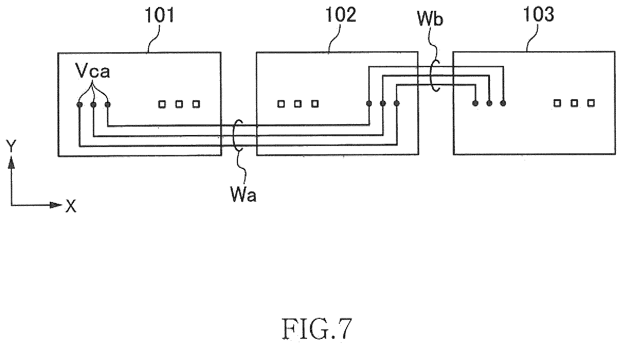

Furthermore, it is possible to make uniform parasitic capacities of the lines that connect the DRAMs because the lines provided in the line layers L3, L4, L6, and L7 can be made substantially equal in line length. On the other hand, as shown in FIG. 7, when the DRAMs aligned in the X direction, the DRAMs 101 to 103, for example, are connected, then lines Wa connecting the via conductors Vca corresponding to the DRAMs 101 and 102 are long whereas lines Wb connecting the via conductors Vca corresponding to the DRAMs 102 and 103 are short. This makes non-uniform the parasitic capacities of the lines that connect the DRAMs. Furthermore, there is a problem that skew occurs because of the difference in line length between a plurality of lines that connect the two DRAMs to each other. To eliminate the skew, it is necessary to detour the other lines in proportion to longest lines, which makes the line layout complicated.

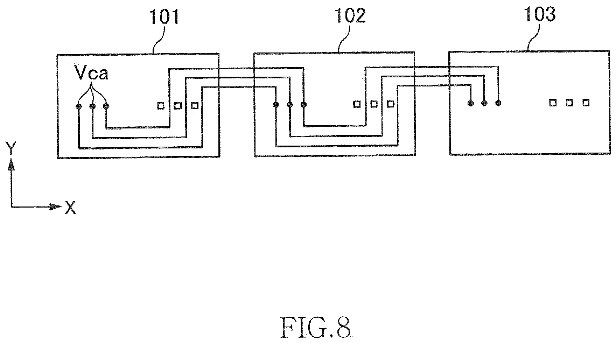

The above problem can be solved by matching the mounting directions of the DRAMs 101 to 103, for example. In this case, lines Wc need to meander in a narrow range as shown in FIG. 8, which causes an increase in line density.

On the other hand, in the present embodiment, as shown in FIG. 6, it is possible to realize the lines that are low in density and equal in length without any of the above problems. Furthermore, it is possible to minimize the influence of crosstalk because the command address-related lines used in the first group and those used in the second group simply intersect without being arranged side by side.

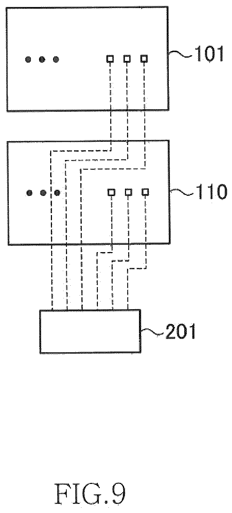

Furthermore, because the two DRAMs (the DRAMs 101 and 110, for example) adjacent in the Y direction differ in the mounting direction by 180°, it is possible to minimize detours when connecting the DRAMs to the corresponding register buffer. On the other hand, as shown in FIG. 9, when the two DRAMs 101 and 111 adjacent in the Y direction are matched in the mounting direction, large detour portions are generated when the DRAMs 101 and 111 are connected to the corresponding register buffer 201. In the present embodiment, it is possible to make line lengths of the data-related lines the smallest without these problems.

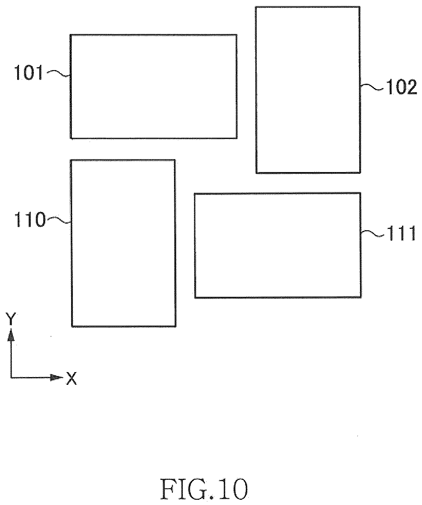

Further, in the present embodiment, the long sides of all the DRAMs 101 to 136 are oriented in the X direction that is the long side direction of the module substrate 20. Therefore, it is possible to secure mounting margins in the short side direction of the module substrate 20. On the other hand, as shown in FIG. 10, when a part of the DRAMs are mounted on the module substrate 20 while rotating by 90°, the mounting margins can be secured only insufficiently in the short side direction of the module 20. Particularly in a case of mounting the register buffers 201 to 218 as described in the present embodiment, the mounting margins tend to be insufficient in the short side direction of the module substrate 20 and it is often impossible to correctly mount all the chips. In the present embodiment, it is possible to correctly mount the register buffers 201 to 218 without any of these problems.

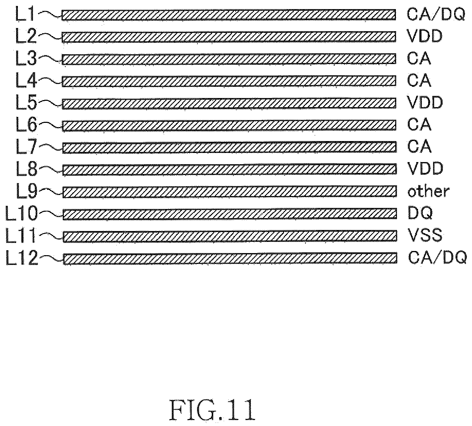

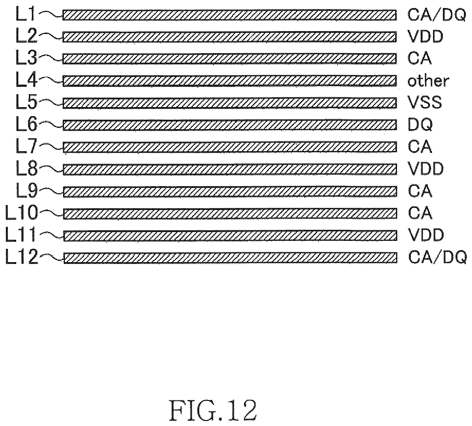

Turning to FIG. 11, 12 line layers L1 to L12 are provided in the module substrate 20. Among these line layers L1 to L12, the line layers L1 and L12 are provided on the surfaces 21 and 22 of the module substrate 20, on which the data-related and command address-related pads P and the lines W connected to these pads P are formed. As described above, the command address-related lines W1 used in the first group are formed in the line layers L3 and L7, and the command address-related lines W2 used in the second group are formed in the line layers L4 and L6. The command address-related lines W3 used in the third group are also formed in the line layers L3 and L7. Similarly, the command address-related lines W4 used in the fourth group are also formed in the line layers L4 and L6. These line layers L3, L4, L6, and L7 are adjacent to the line layers L2, L5, and L8 in which VDD lines are formed. Therefore, all the command address-related lines are laid out with reference to VDD.

Furthermore, lines for the other signals are formed in the line layer L9 and data-related lines are formed in the line layer L10. Because VSS lines are formed in the line layer L11 adjacent to the line layer L10, all the data-related lines are laid out with reference to VSS.

Turning to FIG. 12, the line layers L5 and L11 shown in FIG. 11 are replaced with each other, the line layers L6 and L10 shown in FIG. 11 are replaced with each other, and the line layers L4 and L9 shown in FIG. 11 are replaced with each other. According to this example, very small capacitors are formed between the line layer L2 in which the VDD lines are provided and the line layer L5 in which the VSS lines are provided, and very small capacitors are formed between the line layer L8 in which the VDD lines are provided and the line layer L5 in which the VSS lines are provided. Therefore, it is possible to reduce the inductance of the module substrate 20.

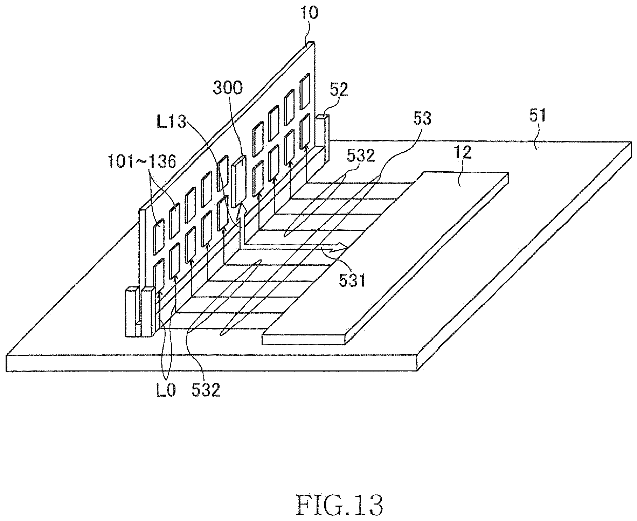

Turning to FIG. 13, a memory slot 52 is provided on the motherboard 51, so that the semiconductor module 10 is inserted in the memory slot 52. On the other hand, a memory controller 12 is directly mounted on the motherboard 51. As described above, the DRAMs 101 to 136 are mounted on the semiconductor module 10. The contents of USSN 12/801,325 filed on June 3, 2010 (US 2010-0312956-A1) are hereby incorporated by reference in their entirety.

On a signal path between the memory controller 12 and the DRAMs 101 to 136, there exist a line 53 formed on the motherboard 21 and the data line L0 and the command/address/control line L3 formed on the semiconductor module 10. The line 53 includes a line 531 which transmits the command signal, the address signal, the control signal, and the clock signal, and data lines 532 which transmit the data signals. Each of the data lines 532 consists of 4 data lines, for example. However, as shown in FIG. 1, in the semiconductor module 10 according to the present embodiment, because the data register buffers 210 to 218 are connected to the data line L0, the memory controller 12 cannot experience the load capacity of the DRAMs 101 to 136 that exist on the signal path beyond the data register buffer s 210 to 218. Similarly, because the command address buffer 300 is connected to the command/address/control line L3, the memory controller 12 cannot experience the load capacity of the DRAMs 101 to 136 that exist on the signal path beyond the command address buffer 300. Therefore, the load capacity of the signal path that connects the memory controller 12 and the semiconductor module 10 is reduced, making it possible to ensure an excellent signal quality even with a high data transfer rate.

Although only a single memory slot 52 is provided on the motherboard 51 in the memory system shown in FIG. 13, in actual cases, a plurality of memory slots (for example, four) are provided on the memory system, so that the semiconductor module 10 is mounted on each of the memory slots . As the number of units of the semiconductor module 10 increases, the load capacity of the signal path increases by the number of semiconductor module 10. However, according to the present embodiment, because the load capacity per semiconductor module is considerably smaller than that of a conventional semiconductor module, it is possible to perform a high speed data transfer even when a plurality of semiconductor modules are mounted.

Furthermore, while FIG. 13 shows an example of mounting the semiconductor module 10 using the memory slot 52, memory devices stacked three-dimensionally-memory devices stacked using TSV can be used in place of the semiconductor module 10, for example. In this case, it suffices to change a shape of the memory slot 52 in proportion to the three-dimensionally stacked memory devices or to mount the three-dimensionally stacked memory devices directly on the motherboard 51.

It is apparent that the present invention is not limited to the above embodiments, but may be modified and changed without departing from the scope of the invention as defined by the appended claims.

For example, while DRAMs are used as semiconductor devices mounted on the module substrate 20 in the above embodiment, the type of the semiconductor devices mounted on the module substrate 20 is not limited to DRAMs. In addition, while register buffers are mounted on the module substrate 20 in the above embodiment, in the present invention, mounting register buffers on a module substrate is not essential.

## Claims

1. A semiconductor module (10) comprising a module substrate (20) and a plurality of semiconductor devices (101 -136) mounted on the module substrate (20) in a first direction (X) and in a second direction (Y) perpendicular to the first direction, the plurality of semiconductor devices (101-136) having the same structure, wherein plan directions of the plurality of semiconductor devices (101-136) are made uniform so that terminals (B) provided thereon match one another in layout, wherein this layout defines a mounting direction of each semiconductor device, and two of the semiconductor devices (101-136) adjacent in the first direction differ in their respective mounting direction by 180°,
**characterized in that** terminals of a group of the semiconductor devices (101-136) matching in their respective mounting direction (101, 103, 105, 111, 113; 102, 104, 110, 112, 114) are commonly connected by a respective line (W1-W4) within the module substrate, and two of the semiconductor devices (101-136) adjacent in the second direction differ in their respective mounting direction by 180°.

2. The semiconductor module as claimed in claim 1,
wherein
the module substrate (20) has a rectangular shape having a long side in the first direction and a short side in the second direction, and
each of the semiconductor devices (101 -136) has a rectangular shape having a long side in the first direction and a short side in the second direction.

3. The semiconductor module as claimed in claim 2,
wherein
the semiconductor devices (101-136) include:
a first semiconductor device;
a second semiconductor device arranged adjacent to the first semiconductor device in the first direction;
a third semiconductor device arranged adjacent to the first semiconductor device in the second direction; and
a fourth semiconductor device arranged adjacent to the third semiconductor device in the first direction and adjacent to the second semiconductor device in the second direction,
the module substrate (20) includes:
a first command address line connected to command address terminals of the first and fourth semiconductor devices; and
a second command address line connected to command address terminals of the second and third semiconductor devices, and the first command address line is formed in a first line layer of the module substrate (20), and the second command address line is formed in a second line layer of the module substrate (20).

4. The semiconductor module as claimed in claim 3,
wherein
semiconductor devices (101 -136) further include:
a fifth semiconductor device arranged adjacent to the second semiconductor device in the first direction; and
a sixth semiconductor device arranged adjacent to the fourth semiconductor device in the first direction and adjacent to the fifth semiconductor device in the second direction,
the module substrate (20) further includes:
a third command address line connected to command address terminals of the fourth and fifth semiconductor devices; and
a fourth command address line connected to command address terminals of the second and sixth semiconductor devices, and the third command address line is formed in a third line layer of the module substrate (20), and the fourth command address line is formed in a fourth line layer of the module substrate (20).

5. The semiconductor module as claimed in claim 4, further comprising a plurality of register buffers (201-218) mounted along the long side of the module substrate (20),
wherein the register buffers (201-218) include:
a first register buffer connected to data terminals of the first and third semiconductor devices;
a second register buffer connected to data terminals of the second and fourth semiconductor devices; and
a third register buffer connected to data terminals of the fifth and sixth semiconductor devices.

6. The semiconductor module as claimed in claim 4 or 5, further comprising a command address buffer (300) mounted on the module substrate (20), the command address buffer (300) having an output terminal that is commonly connected to the first to fourth command address lines.

7. A module substrate comprising a plurality of mounting areas (101a-136a) arranged in a first direction (X) and in a second direction (Y) perpendicular to the first direction, each of said mounting areas being provided for mounting a semiconductor device (101-136), and each of the mounting areas having a plurality of via conductors (V) that penetrate the module substrate (20) and pads (P) configured to be connected to terminals of the semiconductor device, the pads being connected to the via connectors,
wherein the plurality of mounting areas having the same structure, and
the pads (P) provided in the mounting areas match another in layout, wherein this layout defines a direction of each mounting area, and
two of the mounting areas adjacent in the first direction (X) differ in their respective direction by 180°,
**characterized in that**
pads of a group of mounting areas matching in their respective direction (101, 103, 105, 111, 113; 102, 104, 110, 112, 114) are commonly connected by a respective line (W1-W4) within the module substrate, and two of the mounting areas adjacent in the second direction differ in their respective direction by 180°.

8. The module substrate (20) as claimed in claim 7, wherein the module substrate (20) has a rectangular shape having a long side in the first direction and a short side in the second direction.

9. The module substrate (20) as claimed in claim 7 or 8, wherein each of the mounting areas has a rectangular shape having a long side in the first direction and a short side in the second direction.

## Patentansprüche

1. Halbleitermodul (10), umfassend ein Modulsubstrat (20) und eine Vielzahl von Halbleitervorrichtungen (101-136), die auf dem Modulsubstrat (20) in einer ersten Richtung (X) und in einer zweiten Richtung (Y), senkrecht zur ersten Richtung, befestigt sind, wobei die Vielzahl von Halbleitervorrichtungen (101-136) die gleiche Struktur aufweist,
wobei Planrichtungen der Vielzahl von Halbleitervorrichtungen (101-136) einheitlich gestaltet sind, sodass die darauf vorgesehenen Anschlüsse (B) im Layout aufeinander abgestimmt sind, wobei dieses Layout eine Befestigungsrichtung jeder Halbleitervorrichtung definiert, und sich zwei der in der ersten Richtung benachbarten Halbleitervorrichtungen (101-136) in ihrer jeweiligen Befestigungsrichtung um 180° unterscheiden, **dadurch gekennzeichnet, dass** Anschlüsse einer Gruppe von Halbleitervorrichtungen (101-136), die in ihrer jeweiligen Befestigungsrichtung (101, 103, 105, 111, 113; 102, 104, 110, 112, 114) übereinstimmen, gemeinsam durch eine entsprechende Leitung (W1-W4) innerhalb des Modulsubstrats verbunden sind, und sich zwei der Halbleitervorrichtungen (101-136), die in der zweiten Richtung benachbart sind, in ihrer jeweiligen Befestigungsrichtung um 180° unterscheiden.

2. Halbleitermodul nach Anspruch 1,
wobei
das Modulsubstrat (20) eine rechteckige Form mit einer langen Seite in der ersten Richtung und einer kurzen Seite in der zweiten Richtung aufweist, und
jede der Halbleitervorrichtungen (101-136) eine rechteckige Form mit einer langen Seite in der ersten Richtung und einer kurzen Seite in der zweiten Richtung aufweist.

3. Halbleitermodul nach Anspruch 2,
wobei
die Halbleitervorrichtungen (101-136) Folgendes beinhalten:
eine erste Halbleitervorrichtung;
eine zweite Halbleitervorrichtung, die benachbart zu der ersten Halbleitervorrichtung in der ersten Richtung angeordnet ist;
eine dritte Halbleitervorrichtung, die benachbart zu der ersten Halbleitervorrichtung in der zweiten Richtung angeordnet ist; und
eine vierte Halbleitervorrichtung, die benachbart zu der dritten Halbleitervorrichtung in der ersten Richtung und benachbart zu der zweiten Halbleitervorrichtung in der zweiten Richtung angeordnet ist,
das Modulsubstrat (20) Folgendes beinhaltet:
eine erste Befehlsadressleitung, die mit Befehlsadressanschlüssen der ersten und der vierten Halbleitervorrichtung verbunden ist; und
eine zweite Befehlsadressleitung, die mit Befehlsadressanschlüssen der zweiten und der dritten Halbleitervorrichtung verbunden ist, und die erste Befehlsadressleitung in einer ersten Leitungsschicht des Modulsubstrats (20) gebildet ist, und die zweite Befehlsadressleitung in einer zweiten Leitungsschicht des Modulsubstrats (20) gebildet ist.

4. Halbleitermodul nach Anspruch 3,
wobei
Halbleitervorrichtungen (101 -136) ferner Folgendes beinhalten:
eine fünfte Halbleitervorrichtung, die benachbart zu der zweiten Halbleitervorrichtung in der ersten Richtung angeordnet ist; und
eine sechste Halbleitervorrichtung, die benachbart zu der vierten Halbleitervorrichtung in der ersten Richtung und benachbart zu der fünften Halbleitervorrichtung in der zweiten Richtung angeordnet ist,
das Modulsubstrat (20) ferner Folgendes beinhaltet:
eine dritte Befehlsadressleitung, die mit den Befehlsadressanschlüssen der vierten und der fünften Halbleitervorrichtung verbunden ist; und
eine vierte Befehlsadressleitung, die mit Befehlsadressanschlüssen der zweiten und der sechsten Halbleitervorrichtung verbunden ist, und die dritte Befehlsadressleitung in einer dritten Leitungsschicht des Modulsubstrats (20) gebildet ist, und die vierte Befehlsadressleitung in einer vierten Leitungsschicht des Modulsubstrats (20) gebildet ist.

5. Halbleitermodul nach Anspruch 4, ferner umfassend eine Vielzahl von Registerpuffern (201-218), die entlang der langen Seite des Modulsubstrats (20) befestigt sind,
wobei die Registerpuffer (201-218) Folgendes beinhalten:
einen ersten Registerpuffer, der mit Datenanschlüssen der ersten und der dritten Halbleitervorrichtung verbunden ist;
einen zweiten Registerpuffer, der mit Datenanschlüssen der zweiten und der vierten Halbleitervorrichtung verbunden ist; und
einen dritten Registerpuffer, der mit Datenanschlüssen der fünften und der sechsten Halbleitervorrichtung verbunden ist.

6. Halbleitermodul nach Anspruch 4 oder 5, ferner umfassend einen Befehlsadresspuffer (300), der auf dem Modulsubstrat (20) befestigt ist, wobei der Befehlsadresspuffer (300) einen Ausgangsanschluss aufweist, der gemeinsam mit der ersten bis vierten Befehlsadressleitung verbunden ist.

7. Modulsubstrat mit einer Vielzahl von Befestigungsbereichen (101a-136a), die in einer ersten Richtung (X) und in einer zweiten Richtung (Y), senkrecht zur ersten Richtung, angeordnet sind, wobei jeder der Befestigungsbereiche zum Befestigen einer Halbleitervorrichtung (101-136) vorgesehen ist und jeder der Befestigungsbereiche eine Vielzahl von Durchgangsleitern (V), die das Modulsubstrat (20) durchdringen, und Pads (P), die zum Verbinden mit Anschlüssen der Halbleitervorrichtung ausgelegt sind, aufweist, wobei die Pads mit den Durchgangsverbindern verbunden sind,
wobei die Vielzahl von Befestigungsbereichen die gleiche Struktur aufweist, und
die in den Befestigungsbereichen vorgesehenen Pads (P) einander im Layout entsprechen, wobei dieses Layout eine Richtung für jeden Befestigungsbereich definiert, und
sich zwei der in der ersten Richtung (X) benachbarten Befestigungsbereiche in ihrer jeweiligen Richtung um 180° unterscheiden,
**dadurch gekennzeichnet, dass**
Pads einer Gruppe von Befestigungsbereichen, die in ihrer jeweiligen Richtung (101, 103, 105, 111, 113; 102, 104, 110, 112, 114) übereinstimmen, durch eine entsprechende Leitung (W1-W4) innerhalb des Modulsubstrats verbunden sind, und sich zwei der in der zweiten Richtung benachbarten Befestigungsbereiche in ihrer jeweiligen Richtung um 180° unterscheiden.

8. Modulsubstrat (20) nach Anspruch 7, wobei das Modulsubstrat (20) eine rechteckige Form mit einer langen Seite in der ersten Richtung und einer kurzen Seite in der zweiten Richtung aufweist.

9. Modulsubstrat (20) nach Anspruch 7 oder 8, wobei jeder der Befestigungsbereiche eine rechteckige Form mit einer langen Seite in der ersten Richtung und einer kurzen Seite in der zweiten Richtung aufweist.

## Revendications

1. Module semi-conducteur (10) comprenant un substrat de module (20) et une pluralité de dispositifs semi-conducteurs (101-136) montée sur le substrat de module (20) dans un premier sens (X) et dans un second sens (Y) perpendiculaire au premier sens,
la pluralité de dispositifs semi-conducteurs (101-136) présentant la même structure,
dans lequel des sens de plan de la pluralité de dispositifs semi-conducteurs (101-136) sont rendus uniformes de telle sorte que des bornes (B) fournies sur ceux-ci correspondent les unes aux autres en agencement, cet agencement définissant un sens de montage de chaque dispositif semi-conducteur, et deux des dispositifs semi-conducteurs (101-136) adjacents dans le premier sens différant dans leur sens de montage respectif par 180°,
**caractérisé en ce que**
des bornes d'un groupe des dispositifs semi-conducteurs (101-136) correspondant dans leur sens de montage respectif (101, 103, 105, 111, 113 ; 102, 104, 100, 112, 114) sont connectées communément par une ligne respective (W1-W4) dans le substrat de module, et
deux des dispositifs semi-conducteurs (101-136) adjacents dans le second sens diffèrent dans leur sens de montage respectif par 180°.

2. Module semi-conducteur selon la revendication 1,
dans lequel
le substrat de module (20) a une forme rectangulaire présentant un côté long dans le premier sens et un côté court dans le second sens, et
chacun des dispositifs semi-conducteurs (101-136) a une forme rectangulaire présentant un côté long dans le premier sens et un côté court dans le second sens.

3. Module semi-conducteur selon la revendication 2, dans lequel
les dispositifs semi-conducteurs (101-136) comportent :
un premier dispositif semi-conducteur ;
un deuxième dispositif semi-conducteur agencé adjacent au premier dispositif semi-conducteur dans le premier sens ;
un troisième dispositif semi-conducteur agencé adjacent au premier dispositif semi-conducteur dans le second sens ; et
un quatrième dispositif semi-conducteur agencé adjacent au troisième dispositif semi-conducteur dans le premier sens et adjacent au deuxième dispositif semi-conducteur dans le second sens,
le substrat de module (20) comporte :
une première ligne d'adresse de commande connectée à des bornes d'adresse de commande des premier et quatrième dispositifs semi-conducteurs ; et
une seconde ligne d'adresse de commande connectée à des bornes d'adresse de commande des deuxième et troisième dispositifs semi-conducteurs, et la première ligne d'adresse de commande est formée dans une première couche de ligne du substrat de module (20), et la seconde ligne d'adresse de commande est formée dans une seconde couche de ligne du substrat de module (20).

4. Module semi-conducteur selon la revendication 3,
dans lequel
les dispositifs semi-conducteurs (101-136) comportent en outre :
un cinquième semi-conducteur agencé adjacent au deuxième dispositif semi-conducteur dans le premier sens ; et
un sixième dispositif semi-conducteur agencé adjacent au quatrième dispositif semi-conducteur dans le premier sens et adjacent au cinquième dispositif semi-conducteur dans le second sens,
le substrat de module (20) comporte en outre :
une troisième ligne d'adresse de commande connectée à des bornes d'adresse de commande des quatrième et cinquième dispositifs semi-conducteurs ; et
une quatrième ligne d'adresse de commande connectée à des bornes d'adresse de commande des deuxième et sixième dispositifs semi-conducteurs, et la troisième ligne d'adresse de commande est formée dans une troisième couche de ligne du substrat de module (20), et la quatrième ligne d'adresse de commande est formée dans une quatrième couche de ligne du substrat de module (20).

5. Module semi-conducteur selon la revendication 4, comprenant en outre une pluralité de tampons de registres (201-218) montés le long du côté long du substrat de module (20),
dans lequel les tampons de registres (201-218) comportent :
un premier tampon de registre connecté à des bornes de données des premier et troisième dispositifs semi-conducteurs ;
un deuxième tampon de registre connecté à des bornes de données des deuxième et quatrième dispositifs semi-conducteurs ;
un troisième tampon de registre connecté à des bornes de données des cinquième et sixième dispositifs semi-conducteurs.

6. Module semi-conducteur selon la revendication 4 ou 5, comprenant en outre un tampon d'adresses de commande (300) monté sur le substrat de module (20), le tampon d'adresses de commande (300) présentant une borne de sortie qui est connectée communément aux première à quatrième lignes d'adresse de commande.

7. Substrat de module comprenant une pluralité de zones de montage (101a-136a) agencées dans un premier sens (X) et dans un second sens (Y) perpendiculaire au premier sens, chacune desdites zones de montage étant fournies pour monter un dispositif semi-conducteur (101-136), et chacune des zones de montage présentant une pluralité de conducteurs d'interconnexion (V) qui pénètrent dans le substrat de module (20) et des plages de connexion (P) configurées pour être connectées à des bornes du dispositif semi-conducteur, les plages de connexion étant connectées aux connecteurs d'interconnexion,
dans lequel la pluralité de zones de montage présente la même structure, et
les plages de connexion (P) fournies dans les zones de montage correspondent les unes aux autres en agencement, cet agencement définissant un sens de chaque zone de montage, et
deux des zones de montage adjacentes dans le premier sens (X) diffèrent dans leur sens de montage respectif par 180°,
**caractérisé en ce que**
des plages de connexion d'un groupe de zones de montage correspondant dans leur sens respectif (101, 103, 105, 111, 113 ; 102, 104, 100, 112, 114) sont connectées communément par une ligne respective (W1-W4) dans le substrat de module, et
deux des zones de montage adjacentes dans le second sens diffèrent dans leur sens respectif par 180°.

8. Substrat de module (20) selon la revendication 7, le substrat de module (20) ayant une forme rectangulaire présentant un côté long dans le premier sens et un côté court dans le second sens.

9. Substrat de module (20) selon la revendication 7 ou 8, dans lequel chacune des zones de montage a une forme rectangulaire présentant un côté long dans le premier sens et un côté court dans le second sens.
